# EUROPEAN PATENT APPLICATION

(11) **EP 4 484 864 A1**
(43) Date of publication of application: **01.01.2025**
(21) Application number: 23182713.0
(22) Date of filing: 30.06.2023
(51) Int. Cl.: F25D 3/12, F25B 27/00, F25D 17/06

(54) **PASSIVE COOLING UNIT FOR COOLING FOOD, FOOD STORAGE CONTAINER COMPRISING THE PASSIVE COOLING UNIT, AND AIRCRAFT COMPRISING A GALLEY AND AT LEAST ONE SUCH FOOD STORAGE CONTAINER**

(71) Applicant: Airbus Operations GmbH, 21129 Hamburg (DE)
(72) Inventor: Trümper, Torsten, Hamburg (DE); Lohse, Ekkehard, Hamburg (DE); Nörenberg, Nils, Hamburg (DE)

(57) **Abstract**

A passive cooling unit (10) for cooling food, preferably for cooling food received in a storage container (5), is described to comprise an insulation casing (11) insulating an interior (13, 14) of the casing (11) from an environment surrounding the casing (11), the insulation casing (11) having an air inlet (19) and an air outlet (20) and comprising within its interior (13, 14) a dry ice (18) receiving space and at least one airflow channel (17) for guiding air to be cooled. The at least one airflow channel (13) is arranged in airflow communication with the air inlet (19) and the air outlet (20). The unit (10) further comprises at least one electrically operated airflow means (21) adapted to create an airflow through the at least one airflow channel (17), and at least one thermal electrical generator (16) for generating electrical power. The at least one thermal electrical generator (16) arranged in the insulation casing (11) in thermal contact with at least one airflow channel (17) and the dry ice (18) receiving space. The at least one electrically operated airflow means (21) is adapted to receive power generated by the at least one thermal electrical generator (16).

## Description

The present invention relates to a passive cooling unit for cooling food, use of the passive cooling unit within a food storage container and use of such a food storage container equipped with the passive cooling unit in an aircraft galley. Especially, according to the present invention, food is cooled by generating a flow of cooled air around the food by a self-sufficient unit.

In particular, instead of actively cooling air by using, for example, air chillers, the invention is directed to a passive and self-sufficient cooling unit using only dry ice as cooling capacity and even for generating electrical power to operate an airflow means for moving air to be cooled through the passive cooling unit.

Use of dry ice for cooling in aircraft appliances is well known and state of the art. Whenever in-flight meals are prepared in the flight kitchen center, it is known practice to place dry ice on the top portion of the in-flight meal service cart to keep the meals fresh during ground support operations. However, with the low temperature of the dry ice, which usually goes down to approximately -79°C, food in the service cart, especially in the upper region of the service cart close to the dry ice, may suffer from frost damage or even become frozen.

For example, EP 0080313 A1 describes use of dry ice within food service carts usable in aircraft galleys. Dry ice pieces are placed in a tray-like bunker received - in substitution of a meal tray - in an uppermost pair of meal tray ledges. Via an inlet opening of and a fan included in the bunker, air from the interior of the cart is sucked into the bunker and blown onto the dry ice pieces. Thereby, the sucked-in air is cooled and the stream of cooled air is directed towards an outlet opening of the bunker and back into the interior of the cart.

As an alternative not suffering from the above-described food freezing when using dry ice without ventilation, EP 0655592 A1 describes to cool aircraft food service carts when parked in a galley cart receiving space within an aircraft galley by means of heat transfer from a wall of the cart to a heat transfer contact device provided within the galley cart receiving space, the heat transfer contact device being in fluid communication with a cooling fluid circuit of the aircraft. However, such cooling alternative based on contact heat transfer requires the galley to be provided with heat transfer contact devices and ducting for connecting same to a cooling fluid circuit of the aircraft, requiring installation space and adding weight.

As a further alternative, it is also known practice to use air chillers installed in aircraft galleys for cooling of catering trolleys parked therein. However, air chillers suffer from the deficiencies of waste heat and high energy consumption. Moreover, the installation of air chillers adds significant weight to and requires large space within the aircraft. As a further drawback, due to lack of inflammable alternatives, air chillers within aircrafts usually use refrigerants, e.g., HFO gas, which will be banned in the near future. In addition, if directly installed in the aircraft galley, air chillers have the drawbacks of requiring air flow and generating noise. Moreover, the whole galley needs to be designed of higher depth to provide installation space for the air chiller, or the waste/garbage compartment of the galley is rededicated as air chiller installation space and thus is missing - requiring a redesign of the galley and adjacent aircraft sections.

In view of the above, it is an object of the present invention to provide a passive cooling unit for cooling food which overcomes all the above-mentioned deficiencies even though using dry ice as single cooling capacity.

According to a first aspect, a passive and self-sufficient cooling unit for cooling food by means of dry ice used as single cooling capacity is described. The passive cooling unit preferably is adapted for use with a food storage container, e.g., a trolley or a galley insert, for cooling food received in said food storage container.

According to claim 1, the passive cooling unit comprises an insulation casing insulating an interior of the casing from an environment surrounding the casing, which, when used with a food storage container, is the interior and/or exterior of the container. The insulation preferably reduces uncontrolled heat intake from the surrounding into the casing. For example, if placed within a container which preferably is also insulated against heat intake, the casing is insulated from the interior of the container. If the container is not or not sufficiently insulated and the casing is arranged within the container in contact with one of its outer walls having a material allowing thermal transfer, the casing further insulates against the surrounding of the container. As a further example, if placed on top or below a preferably insulated container, the casing is insulated from the exterior of the container. If the container is not or not sufficiently insulated and the casing is arranged on top or below the container in contact with one of its outer walls having a material allowing thermal transfer, the casing further insulates against the interior of the container.

The insulation casing has an air inlet and an air outlet, respectively adapted to communicate with an exterior of the casing, which, when used with a container, is an interior, i.e., a food storage compartment, of the container. The air inlet of the insulated casing allows for controlled heat intake, via the air entering the air inlet, into the unit, which is important to allow for reproduceable control of the operation of the unit as will be detailed below.

The unit preferably is of handleable size and weight and may comprise means for closing the air inlet and air outlet for handling, i.e., when not in use.

Moreover, the casing comprises within its interior a dry ice receiving space, in which dry ice preferably in the form of dry ice plates or blocks is received, and at least one airflow channel for guiding air to be cooled. Preferably, the insulation casing comprises an upper compartment forming at least in one section thereof the dry ice receiving space, and a lower compartment in at least one section thereof the at least one airflow channel is formed. The dry ice receiving space may be accessible via a closable opening of the casing - separate from the air inlet and the air outlet - for placing the dry ice within the casing prior to use of the unit. The at least one airflow channel of the casing is arranged in airflow communication with the air inlet and the air outlet so that, when the unit is used with a food storage container, air present in the food storage compartment of the food storage container can enter the unit at its air inlet and exit the unit as cooled air at its air outlet.

For creating a preferably constant/continuous airflow through the at least one airflow channel in a desired direction from the air inlet to the air outlet, i.e., the airflow necessary to suck in air through the air inlet of the unit and to discharge/blow out cooled air through the air outlet of the unit, the passive cooling unit further comprises at least one electrically operated airflow means. Said at least one electrically operated airflow means is preferably arranged in a section of the unit which is closer to the air outlet than to the air inlet. Especially, the at least one airflow means can be arranged at the outlet side, i.e., within an air outlet region of the insulation casing, and may even be positioned directly within or at the air outlet of the casing. For the at least one airflow means comprising an air intake side and an air output side opposite the air intake side, a direct position of the at least one airflow means in the at least one air outlet of the casing may, for example, be realized by positioning the at least one airflow means within the casing such that its air output side faces and/or fits onto or even into the air outlet of the casing. Moreover, said at least one electrically operated airflow means preferably is a fan.

The unit still further comprises at least one thermal electrical generator for generating electrical power for operation of the at least one electrically operated airflow means. Said at least one thermal electrical generator, which may be realized as a Peltier element, is arranged in the insulation casing in thermal contact with at least one airflow channel and the dry ice receiving space. Preferably, said at least one thermal electrical generator is sandwiched between at least one airflow channel and the dry ice receiving space. For the insulation casing comprising upper and lower compartments, the at least one thermal electrical generator can be sandwiched between said upper and lower compartments, e.g., within a wall separating the lower and upper compartments, or can be arranged in a region separating the lower and upper compartments, e.g. next to or abutting such a separation wall, within the lower or upper compartment. For example, it is conceivable that there is a through hole in at least a section of said separation wall extending between the lower and upper compartments within the casing, with the at least one thermal electrical generator positioned in the region of the through hole, for example, within the lower compartment, to allow for direct contact with dry ice when placed in the dry ice receiving space, i.e., in the upper compartment. One may think about dimensioning the through hole such that the at least one thermal electrical generator, when in position within the casing, fits into and, thus, closes the through hole. The at least one thermal electrical generator usually is plate shaped. Thus, a rectangular through hole can be easily dimensioned to fit such plate shape. It is conceivable to provide the casing with a further closable opening for inserting and/or removing (for maintenance reasons) the at least one thermal electrical generator. It is conceivable to provide the casing with a drawer, which is preferably frame-like so as to hold the at least one thermal electrical generator only at its lateral circumference so as to allow lower and upper plates of the thermal electrical generator(s) when placed within the casing to be in optimal, i.e., preferably direct, contact with the dry ice one the one hand and with at least one airflow channel on the other hand. Ledges guiding the drawer can be sloped so as to allow the above-mentioned closing of the separation wall through hole with the thermal electrical generator(s). Generally, the better the thermal transfer from air entering the at least one air flow channel at the air inlet of the casing to the at least one thermal electrical generator at the one hand and from the dry ice, i.e., the cooling effect of the dry ice, on the at least one thermal electrical generator on the other hand is, the higher is the power generation capability of the at least one thermal electrical generator. In short, the higher the temperature difference on both sides of the at least one thermal electrical generator is, the higher is its electrical power generation. I.e., thermal transfer with low losses of the transferred heat - i.e., not affected by uncontrolled heat intake via the casing, which is excluded by its insulation - is desired. In other words, heat transfer via direct or at least close to direct contact of the medium carrying the heat to be transferred is desired, wherein also the cold of the dry ice is considered as (negative) heat. Thus, the dry ice can be effectively used for power generation for operation of the unit.

The unit preferably comprises a plurality of cooling channels including the at least one cooling channel arranged in thermal contact with the at least one thermal electrical generator, and at least one further cooling channel not arranged in thermal contact with the at least one thermal electrical generator. It is however, conceivable that the at least one cooling channel not arranged in thermal contact with the at least one thermal electrical generator instead is in thermal contact with dry ice received in the dry ice receiving space. The dry ice then is in thermal transfer contact with the air flowing through the at least one airflow channel not arranged in thermal contact with the at least one thermal electrical generator. Said thermal contact may be realized via a wall covering the cooling channel(s) and/or via a separation wall separating the lower and upper compartments, if present, wherein either of said walls may be provided with one or more openings therethrough to improve thermal transfer. It is however also conceivable that at least in the region of the dry ice receiving space, neither a separation wall (section) nor a cover wall of the cooling channel(s) is present so that a direct thermal contact between the air flowing through the cooling channels on the one hand and the dry ice as well as the thermal electrical generator(s) on the other hand is provided.

In order to optimize thermal transfer for air flowing through the at least one airflow channel, the at least one airflow channel can be provided with a plurality of cooling fins extending within the airflow channel along an airflow guidance direction of the airflow channel. Preferably, the cooling fins extend from a wall of the at least one airflow channel which faces the at least one thermal transfer generator and/or the dry ice receiving space, i.e., a cover wall as mentioned above. Such fins would be in good thermal contact to the at least one thermal transfer generator and/or dry ice receiving space to allow for the above-mentioned close to direct contact of the air flowing through the at least one airflow channel, thereby allowing thermal transfer with low losses of transferred heat. Moreover, it is also conceivable that the cooling fins extend completely through the at least one airflow channel, thereby forming cooling channel partition walls, resulting in separation of the at least one airflow channel into a plurality of parallel airflow channels, wherein this latter design of the cooling fins is also possible for the cover wall being omitted.

According to the present invention, it is preferred that said at least one electrically operated airflow means is arranged in a section of the unit, which, from an air flow perspective direction from the air inlet towards the air outlet, is downstream a location of the at least one thermal electrical generator.

For supplying power generated by the at least one thermal electrical generator from the at least one thermal electrical generator to the at least one electrically operated airflow means, the unit can further comprise power supply means, such as wiring, connecting the at least one thermal electrical generator to the at least one electrically operated airflow means.

If a plurality of cooling channels including at least one cooling channel arranged in thermal contact with the at least one thermal electrical generator and at least one cooling channel not arranged in thermal contact with the at least one thermal electrical generator is present, according to a preferred embodiment, the at least one cooling channel arranged in thermal contact with the at least one thermal electrical generator is thermally insulated from the at least one further cooling channel not arranged in thermal contact with the at least one thermal electrical generator. Such thermal insulation can, for example, be realized by a thermally insulating separation wall provided between the at least one cooling channel arranged in thermal contact with the at least one thermal electrical generator and the at least one further cooling channel not arranged in thermal contact with the at least one thermal electrical generator.

Because of the sublimation of the dry ice in the dry ice receiving space - caused by the dry ice cooling one side of the at least one thermal electrical generator (whereas heat from an airflow through the unit's cooling channel(s) is transferred to the opposite side of the at least one thermal electrical generator) and/or the thermal contact between the dry ice and the air flowing through the at least one airflow channel not in thermal contact with the at least one thermal electrical generator -, for each operation level of the unit as will be further detailed below - a constant amount of gaseous CO₂ is released in use. In this regard, it is advantageous for the dry ice receiving space to be in gaseous communication with the at least one airflow channel for gaseous CO₂ release out of the dry ice receiving space and into a stream of air guided through the unit. Such a communication can be realized by a drainage hole, provided, for example, in a separation wall separating the upper compartment, at least a section of which forms the dry ice receiving space, from the lower compartment, in at least a section of which the cooling channel(s) are formed, allowing the gaseous CO₂ to drain into the air stream guided through the unit. Such gaseous communication is preferably realized in a region of the casing prior to said air stream guided through the casing exiting the casing, i.e., downstream of the air stream exiting the unit but, preferably, upstream a position of the dry ice receiving space relative to the at least one cooling channel. Moreover, such gaseous communication is preferably realized with at least one of the airflow channel(s) or with a common mixing section of all airflow channels upstream an air outlet side of said airflow channels and downstream the air outlet of the unit. When the gaseous CO₂ drains into the at least one airflow channel or common mixing section, it gets mixed together with the air guided through the airflow channel(s). Thereby, it can be ensured that the pressure in the casing does not rise significantly. Moreover, as a further advantageous effect, mixing the air guided through the unit with the gaseous CO₂ within the unit further lowers the temperature of the air exiting the unit. Accordingly, the dry ice is not only used for power generation but also serves as heat sink.

The passive cooling unit preferably further comprises a controller adapted to control operation of the unit and, especially, a temperature of the air exiting the casing, wherein different control approaches are conceivable. Said controller is preferably powered by the at least one thermal electrical generator and can be connected thereto and/or to the at least one airflow means in a wired or wireless manner.

One control approach may focus on controlling a ventilation speed of the at least one airflow means in dependency of a temperature desired to be present within a container with which the unit can be used. In fact, the higher the power supply to the at least one airflow means is, the higher is its ventilation speed. Such a control can be realized by means of a thermally modifiable resistance and/or one or more thermal switches limiting or regulating the supply of electrical power to the at least one airflow means. Thus, this control approach is an electrical control approach.

An alternative control approach may be a mechanical control approach. For a mechanical control to be applicable, the unit has to be further provided with means for selectively blocking or closing one or more of the cooling channels so as to shut down airflow through said one or more airflow channels. Especially for at least one cooling channel being separated, e.g., by partition walls or fins acting as partition walls, into a plurality of parallel cooling channels, slidable cover means for selectively closing one or more of the cooling channels are conceivable. In case of presence of a plurality of cooling channels within the casing, including at least one cooling channel arranged in thermal contact with the at least one thermal electrical generator and at least one cooling channel not arranged in thermal contact with the at least one thermal electrical generator, slidable cover means for selectively closing at least one or, preferably in a stepwise manner, even up to all cooling channels not arranged in thermal contact with the at least one thermal electrical generator can be provided. For the cooling channel(s) arranged in thermal contact with the at least one thermal electrical generator, it is however necessary to leave at least one cooling channel open for allowing the at least one thermal electrical generator to generate at least the minimum power necessary for operating the at least one airflow means at its lowest ventilation speed still ensuring airflow through the unit. The mechanical control approach is based on controlling selective positioning of the at least one blocking means or slidable cover means to close either none or one or more of the cooling channels in dependency of the temperature desired to be present within the container with which the unit can be used.

Both controls are preferably based on a feedback control of the controller, comparing a temperature present within the container, i.e., within the food storage compartment of the container, which can be measured by a temperature sensor within the container, with the desired temperature. Both controls aim to minimize a delta, i.e., difference, between the measured and desired temperatures. For example, if the delta is large, none of the cooling channels would be blocked.

By either one of the above thermal or mechanical cooling unit controls, the temperature within the container preferably is regulated to be around 4°C to 7°C. However, of course also other desired temperatures can be achieved by said controls. Moreover, only one control can be used or both controls in combination.

According to a second aspect, a container for storing food is described to comprise the above-described passive and self-sufficient cooling unit for cooling food by means of dry ice used as single cooling capacity. The food storage container for cooling food received therein preferably is a trolley or a galley insert, known for use with conventional aircraft galleys.

According to claim 12, the food storage container comprises an interior compartment for receiving and storing food, and at least one cooling unit having the above-described features. Usually, food storage containers, especially of trolley and/or galley insert unit type, have a food storage compartment provided with lateral ledges at vertically spaced apart levels for accommodation of food trays carrying food to be stored. Preferably, the cooling unit is provided with means adapted to cooperate with a pair of said lateral ledges in order to be received in one of the vertically spaced levels. Alternatively, it is also conceivable for the storage container to comprise a grid-like tray into or onto which the cooling unit can be placed without affecting the air intake into and air output from the cooling unit.

Especially, regarding the thermal principle that cold air sinks down, one preferred position for the cooling unit within the container is at the uppermost level of the food storage compartment. This position supports the circulation of air within the food storage compartment and, thus, minimizes the operation speed requirements of the at least one airflow means. Depending on the size of the cooling unit which again depends on the cooling capacity to be provided by the cooling unit, i.e., on the volume of the compartment to be cooled and/or the time span the compartment is to be kept cool, the uppermost level at which the cooling unit can be provided must not be the uppermost pair of ledges but can also be a lower pair of ledges in case a height of the cooling unit exceeds a height of the uppermost one of the vertically spaced levels.

However, as an alternative position within the container, it is also conceivable to position the cooling unit at a lower or the lowest level of the food storage compartment and even (directly) on the bottom of the food storage compartment. In the latter case, depending on the height of the cooling unit used and the distance of the lowest tray receiving level from the bottom, the container can be cooled even without blocking a single one of the tray receiving levels.

For the cooling unit being used with a trolley having wheels for moving same on a ground, it is also conceivable to arrange the at least one cooling unit at an outer bottom surface of the trolley facing a floor on which the trolley is movable. In other words, the at least one cooling unit can be mounted onto the bottom wall of the trolley between its wheels. For such an arrangement, it is necessary to modify the trolley bottom wall to be formed with through holes for communicating with the air inlet and air outlet of the at least one cooling unit so as to allow air from the trolley interior to enter the air inlet of the cooling unit via at least one first through hole, and to allow air exiting the cooling unit via its air outlet to enter the trolley interior via at least one second through hole.

As the casing of the cooling unit is thermally insulated against thermal transfer, irrespective of its position within the container or under the trolley, there is no risk of freezer burns. Moreover, the thermal insulation of the casing minimizes uncontrolled heat intake via surfaces of the casing and thereby ensures that the thermal transfer of the cold of the dry ice and the heat of the intake air to the at least one thermal electrical generator is as needed to guarantee that the maximum of power generatable by the at least one thermal electrical generator can be generated. Said maximum power corresponding to a highest possible operation level, i.e., highest possible ventilation level, for the at least one airflow means used together with the at least one thermal electrical generator in the unit. Then, the at least one airflow means can be controlled as desired in a stepwise manner of ventilation levels ranging from the highest ventilation level to a lowest ventilation level still able to ensure airflow through the cooling unit. Preferably, the airflow generated by the at least one airflow means is constant/continuous for each operation/ventilation level. A constant airflow through the cooling unit also ensures a constant circulation of air within an interior of a container with which the cooling unit is used. Such constant ventilation is important to guarantee a homogeneous temperature within the interior of the container and, thereby, avoid cold spots which can lead to freezer burn.

As a third aspect, claim 15 is directed to an aircraft comprising an aircraft galley with at least one container receiving space, and at least one above-described container, wherein each container either is a trolley receivable in a trolley receiving space of the aircraft galley or is a galley insert receivable in a galley insert receiving space of the aircraft galley.

The advantages of the above-described passive cooling unit using dry ice as single cooling capacity are that the drawbacks of the use of dry ice according to the state of the art and the use of air chillers can be avoided. Especially, compared to the known use of air chillers, use of the claimed cooling unit reduces heat waste, on board energy consumption, weight, and galley depth and removes refrigerants which are in conflict with EU relations for F gases. Moreover, the present cooling unit can be easily installed into commonly available aircraft food storage containers, such as trolleys and/or galley units. In fact, due to its compact size, preferably maximally of food tray dimension in length and width, the cooling unit can be easily handled and inserted into an interior food storage compartment of such a container. Therefore, retrofitting such known containers with a self-sufficient cooling unit according to the present invention is easily possible - even without modification. Thereby, a trolley or galley insert can be easily transferred into a mobile refrigerator without necessitating modification. Further, the claimed cooling unit guarantees a continuous cooling chain from the flight kitchen center to the servicing time within the aircraft without the risk of freezer burn or freezing. Furthermore, different sizes of the cooling unit can be provided and chosen depending on the cooling capacity to be provided by the cooling unit, i.e., depending on the volume of the compartment to be cooled and/or the time span the compartment is to be kept cool.

A detailed description of exemplary embodiments of the claimed passive cooling unit and its use with an aircraft trolley is given in the following with reference to the figures which show schematically:
- Fig. 1: a general view of an aircraft, in this case a civil transport jet airplane;
- Figs. 2A and 2B: longitudinal sections through a passive cooling unit according to a first and a second embodiment, respectively;
- Fig. 3: a cross-section through the passive cooling unit of Fig. 2A;
- Figs. 4A and 4B: different positions within an aircraft trolley for the passive cooling unit embodiments of Figs. 2A and 2B; and
- Fig. 5: a mounting position for a modified cooling unit embodiment at an outer side of an aircraft trolley.

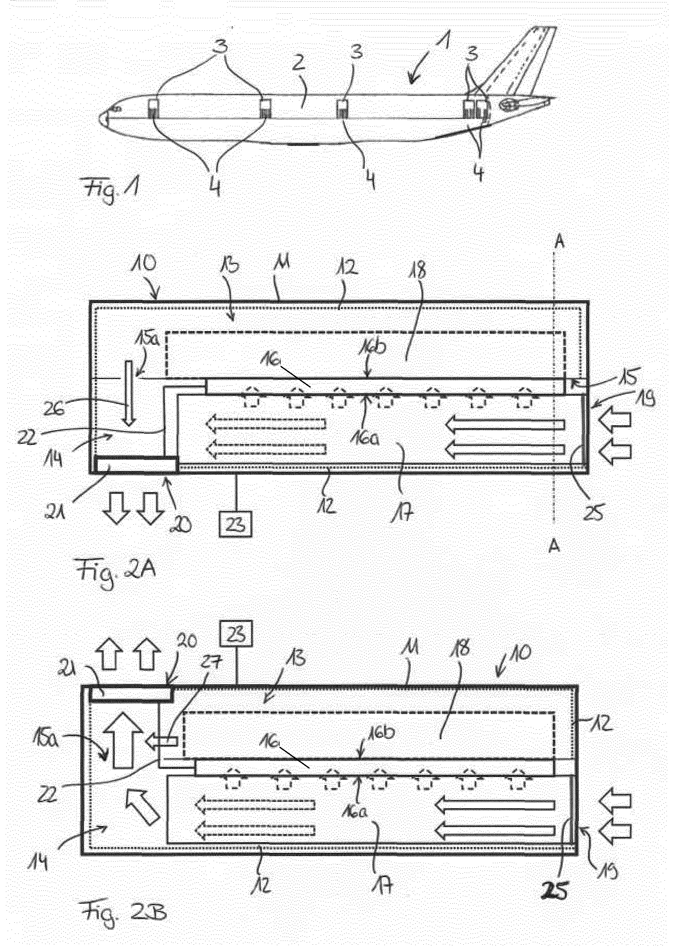

Fig. 1 shows an aircraft 1, especially a civil transport jet airplane, having a passenger cabin area 2 including a plurality of galley regions 3, each provided with at least one container receiving space 4.

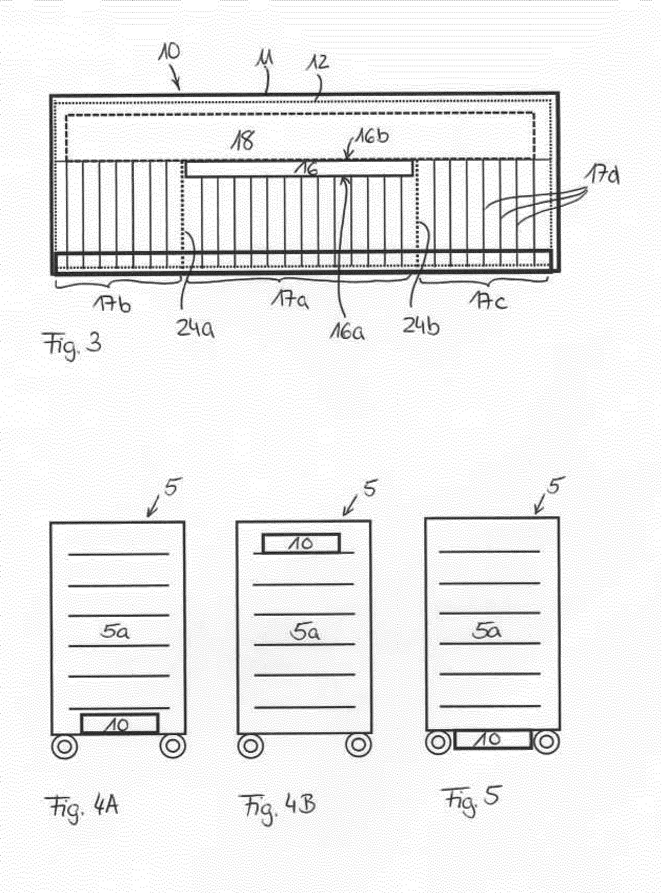

Figs. 2A and 2B illustrate longitudinal sections through first and second embodiments of a passive cooling unit 10 usable with a container 5 receivable within the at least one container receiving space 4 of an aircraft galley region 3 shown in Fig. 1. Each of figs. 4A, 4B and 5 shows a container 5 in the form of a trolley, provided with a passive cooling unit 10 of either Fig. 2A or Fig. 2B receivable in one of the container receiving spaces 4 of Fig. 1.

Each of the first and second embodiments of the passive cooling unit 10 shown in Figs. 2A and 2B comprises the components described in the following. The unit 10 has an insulated casing 11 shown to have a box shape. Of course other shapes are possible as far as the functionality of the unit 10 is not affected. For insulation, the casing 11 is provided with an insulation layer 12 on an inner surface of the casing 11. The casing 11 is divided into an upper compartment 13 and a lower compartment 14 by a separation wall 15. A section of the upper compartment 13 is designed as dry ice receiving space and preferably has a closable access opening (not shown) for accessing the upper compartment 13, especially for inserting dry ice 18. The lower compartment 14 is provided with a receiving space for at least one thermal electrical generator 16 - one of which is shown inserted in the lower compartment 14 in Figs. 2A and 2B -, and with a plurality of cooling channels 17 for guiding air to be cooled (one of which being visible in the longitudinal section view of Figs. 2A and 2B). The separation wall 15 has a communication opening 15a allowing the upper compartment 13 to communicate with the lower compartment 14, i.e., connecting a space of the upper compartment 13 with a space of the lower compartment 14. The at least one thermal electrical generator 16 is received sandwiched between the dry ice receiving space and a sub-set of the plurality of cooling channels 17 so as to provide for optimal thermal contact between a first surface 16a of the thermal electrical generator 16 with the sub-set of the cooling channels 17, on the one hand, and between a second surface 16b of the thermal electrical generator 16 with dry ice 18 shown received in the dry ice receiving space of the upper compartment 13, on the other hand, the first and second surfaces 16a, 16b of the thermal electrical generator 16 extending in parallel to one another. A material of the separation wall 15 may be chosen and/or the separation wall 15 may be provided with cutouts in the thermal contact region between the dry ice 18 and the second surface 16b of the thermal electrical generator 16 so as to allow for and/or support said thermal contact. Moreover, a material forming the plurality of cooling channels 17 and especially the subset in contact with the first surface 16a of the thermal electrical generator 16 may be chosen and/or a thickness of a wall closing the subset of cooling channels 17 off from and facing the first surface 16a of the thermal electrical generator 16 may be reduced to a minimum or said wall may even be omitted so as to allow for and/or support said thermal contact. The unit 10 further comprises an air inlet 19 and an air outlet 20, which may be closable for transport, i.e., during non-use. The air inlet 19 is any kind of cutout or cutouts in the casing 11 allowing air to enter the casing 11. The air inlet 19 is located so as to allow ambient air, i.e., air surrounding the unit, which is air inside a container when used therewith, to enter the plurality of cooling channels 17 and the air outlet 20 is located so as to allow the then cooled air to exit the unit 10. At least one electrically operated airflow means such as a fan 21 is arranged at the air outlet 20 of the unit 10, preferably within the casing 11 as shown in Figs. 2A and 2B. The fan 21 is electrically connected to the thermal electrical generator 16 via wiring 22 and is adapted to establish an airflow through the unit 10 by generating a suction effect in a manner that air is sucked in the unit 10 through its air inlet 19 and blown out the unit 10 through its air outlet 20. Moreover, the unit 10 comprises a controller 23 for controlling operation of the unit 10 as will be detailed further below.

Fig. 3 is a cross sectional view when cutting off a right hand section of the unit 10 of Fig. 2A along line A-A and viewing into the left over left hand section thereof. Fig. 3 shows the plurality of cooling channels 17 to have a subset 17a laterally limited by insulation walls 24a and 24b from side sets 17b and 17c of cooling channels flanking the subset 17a. As is clear from Fig. 3, with the cooling channel arrangement shown, thermal transfer is not only possible to the at least one thermal generator 16 via the subset 17a of cooling channels but also between the dry ice 18 and the cooling channel side sets 17b, 17c. One may understand each of the subset 17a and side sets 17b, 17c of cooling channels to be a single respective main channel (thermally insulated to one another and) intersected into plural parallel channels by internal partition walls 17d having the function of thermally conductive fins.

When used with a container 5, such as the trolley of one of Figs. 4A, 4B or 5, the air inlet 19 is in communication with an interior 5a of the container 5 and air present within the interior 5a of the container 5 will enter the plurality of cooling channels 19 via the air inlet as soon as the unit 10 is in use. There will be a thermal transfer from the air present within the cooling channel subset 17a to first surface 16a of the at least one thermal electrical generator 16 (indicated by thick broken-lined arrows in Figs. 2A and 2B) and from the dry ice 18 present within the dry ice receiving space of the upper compartment 13 to the second surface 16b of the at least one thermal electrical generator 16. These thermal transfers to the first and second surfaces 16a, 16b, arranged opposite to one another, of the at least one thermal electrical generator 16 cause generation of electrical power within the thermal electrical generator(s) 16. This electrical power is supplied to the at least one electrically operated airflow means, here the fan 21, for operation of same. Upon supply of power to the fan 21, controlled operation of the unit 10 starts. There will also be thermal transfer between air present within the cooling channel side sets 17b, 17c and the dry ice 18. When the fan 21 is operating, i.e., sucking air, an airflow is generated within the plurality of cooling channels 17 in a direction from the air inlet 19 of the unit 10 to the air outlet 20 of the unit 10. Thereby, when compared to the air temperature at the air outlet 20, air of a higher temperature enters the unit 10 via its air inlet 19, is cooled in the unit 10 when flowing through the cooling channels 17 via thermal transfer, and exits the unit 10 at a lower temperature, compared to the air temperature at the air inlet 19. The airflow through the cooling channels 17 is indicated by two pairs of parallel thin arrows in Figs. 2A and 2B, wherein the pair of filled black arrows indicate a flow of air having a temperature still close to the air entering the unit 10 at the air inlet 19 and the pair of non-filled contoured arrows indicate a flow of already cooled-down air having a temperature close to the air exiting the unit 10 at the air outlet 20.

The cooling effect of the unit 10, i.e., the temperature difference between air entering the unit 10 at its air inlet 19 and air exiting the unit 10 via its air outlet 20, is controllable via controller 23 as follows. After startup, i.e., from a point in time the at least one thermal electrical generator 16 is generating power, there is a mechanical and an electrical control possible for operation of the unit 10, wherein these controls may be combined or used separately. As to the electrical operation control, the controller 23 is adapted to control the operation speed of the fan 21 by controlling the amount of energy supplied to the fan 21. For the mechanical operation control, the unit 10 has to be further provided with movable blocking means 25, such as laterally movable covers, for selectively blocking at least some but not all of the cooling channels of the cooling channel subset 17a and/or for selectively blocking up to all of the cooling channels of the lateral side sets 17b, 17c. Depending on the amount of air present within the cooling channel subset 17a, the extent of possible thermal transfer to the at least one thermal electrical generator 16 and, thus, the amount of power generated by the thermal electrical generator 16 and supplyable to the fan 21 can be controlled. When none of the cooling channels of the subset 17a is blocked, the maximum amount of power can be generated by the thermal electrical generator(s) 16 so that operation of the fan 21 is possible at a high speed level and, maximally, at the highest possible speed level corresponding to said maximum amount of power available. By increasing the number of blocked cooling channels of the subset 17a, the amount of power generated by the thermal electrical generator(s) 16 and, as a consequence, the speed level at which the fan 21 can operate at its maximum decrease correspondingly. Thereby, the operation of the unit 10 is slowed down so that the volume of cooled air exiting the unit 10 is decreased. By selectively blocking none, some or even all of the cooling channels of each of the side sets 17b, 17c, the cooling effect can be further affected. The more cooling channels of the side sets 17b, 17c are unblocked, the higher is the volume of cool air mixed to the air flowing through the unblocked channels of the subset 17a prior to exiting the unit 10 and the higher is the amount of cool air within the volume of air exiting the unit 10, and vice versa.

Now the function of the separation wall communication opening 15a will be explained with reference to each of Figs. 2A and 2B.

In the embodiment of the unit 10 shown in Fig. 2A, the air outlet 20 is located in a region of a bottom wall of the unit 10 so that air exiting the unit 10 is blown out downwards from the unit 10. The communication opening 15a of this embodiment is sized to allow gaseous CO₂ generated due to the thermal transfer between the air present in and/or flowing through the cooling channels and the dry ice to drop down from the upper compartment 13 to the lower compartment 14 wherein this gaseous CO₂ mixes with the cooled air prior to the latter exiting the unit 10. This gaseous drop-down is indicated by a thin vertical arrow 26 in Fig. 2A.

In the embodiment of the unit 10 shown in Fig. 2B, the air outlet 20 is located in a region of the top wall of the unit 10 so that air exiting the unit 10 is blown out upwards from the unit 10. The communication opening 15a of this embodiment is sized to allow the airstream flowing through the cooling air channels 17 to exit the unit 10 via a section of the upper compartment 13 which is different from and adjacent to its dry ice receiving space. Here, the gaseous CO₂ is sucked into said airstream (as indicated by arrow 26) by the latter flowing through the upper compartment 13.

All other arrows indicated in Figs. 2A and 2B, which have not been further specified above, serve to further illustrate the airflow through into, through and out of the respective unit 10.

The embodiment of the unit 10 of Fig. 2A is designed for being placed in an upper section of the interior 5a of the container 5 as shown in Fig. 4B. The embodiment of the unit 10 of Fig. 2B is designed for being placed in a lower section of the interior 5a of the container 5, such as on an inner surface of a bottom wall thereof, as shown in Fig. 4A. The container 5 of Figs. 4A, 4B and 5 are shown to have lateral ledges for receiving food trays. According to Fig. 4A, the unit 10 is shown placed below a pair of lowest lateral ledges. According to Fig. 4B, the unit 10 is shown placed in the region of the uppermost pair of lateral ledges. The relative arrangement of the air inlet 19 and air outlet 20 of each of the units 10 shown in Figs. 2A and 2B is adapted to allow for circulation of air within the interior 5a of the container 5, when located therein in accordance with Figs. 4B and 4A, respectively.

For arranging the unit 10 between rollers 5b of the container 5 as shown in Fig. 4, the unit 10 according to the embodiment shown in Fig. 2B has to be modified in that the airflow is guided in a U-shape around the dry ice receiving region of the upper compartment 13 of the unit 10, i.e., so that not only the air outlet 20 blows air upwardly out of the unit 10 but also the air inlet 19 is arranged within a region of the top wall of the unit for air to enter the unit 10 from above. Such a modified relative arrangement of the air inlet 19 and the air outlet 20 of the unit 10, when mounted to the outer surface of the bottom wall of the container 5 as shown in Fig. 4, is adapted to allow for circulation of air within the interior 5a of the container 5 - given presence of openings in the container bottom wall in correspondence to the air inlet 19 and the air outlet 20 of the modified unit 10, allowing communication of the unit 10 with the interior 5a of the container 5.

## Claims

1. Passive cooling unit (10) for cooling food, preferably for cooling food received in a storage container (5), the passive cooling unit (10) comprising:
an insulation casing (11) insulating an interior (13, 14) of the casing (11) from an environment surrounding the casing (11), the insulation casing (11) having an air inlet (19) and an air outlet (20) and comprising within its interior (13, 14):
a dry ice (18) receiving space, and
at least one airflow channel (17) for guiding air to be cooled, the at least one airflow channel (13) arranged in airflow communication with the air inlet (19) and the air outlet (20);
at least one electrically operated airflow means (21) adapted to create an airflow through the at least one airflow channel (17); and
at least one thermal electrical generator (16) for generating electrical power, the at least one thermal electrical generator (16) arranged in the insulation casing (11) in thermal contact with at least one airflow channel (17) and the dry ice (18) receiving space,
wherein the at least one electrically operated airflow means (21) is adapted to receive power generated by the at least one thermal electrical generator (16).

2. Passive cooling unit (10) according to claim 1, wherein the insulation casing (11) comprises an upper compartment (13) at least a section thereof forming the dry ice (18) receiving space and a lower compartment (14) in which the at least one airflow channel (17) is formed.

3. Passive cooling unit (10) according to claim 1 or 2, wherein the at least one thermal electrical generator (16) is received within the insulation casing (11) sandwiched between the dry ice (18) receiving space and the at least one airflow channel (17) in thermal contact with which the at least one thermal electrical generator (16) is arranged.

4. Passive cooling unit (10) according to any one of claims 1 to 3, wherein the at least one airflow channel (17) is provided with a plurality of cooling fins (17d) extending within the airflow channel along an airflow guidance direction of the airflow channel (17).

5. Passive cooling unit (10) according to any one of claims 1 to 4, comprising a plurality of cooling channels (17) including the at least one cooling channel (17a) arranged in thermal contact with the at least one thermal electrical generator (16), and at least one further cooling channel (17b, 17c) not arranged in thermal contact with the at least one thermal electrical generator (16).

6. Passive cooling unit (10) of claim 5, wherein the at least one cooling channel (17a) arranged in thermal contact with the at least one thermal electrical generator (16) is thermally insulated from the at least one further cooling channel (17b, 17c) not arranged in thermal contact with the at least one thermal electrical generator (16), wherein, preferably, the thermal insulation is realized by a thermally insulating separation wall (24a, 24b) provided between the at least one cooling channel (17a) arranged in thermal contact with the at least one thermal electrical generator (16) and the at least one further cooling channel (17b, 17c) not arranged in thermal contact with the at least one thermal electrical generator (16).

7. Passive cooling unit (10) of any one of claims 1 to 6, wherein the dry ice (18) receiving space is in gaseous communication with the at least one airflow channel (17) for gaseous CO2 release out of the dry ice (18) receiving space and into a stream of air guided through the insulation casing (11).

8. Passive cooling unit (10) of any one of claims 1 to 7, wherein the at least one airflow means (21) is arranged at the outlet side of the insulation casing (11).

9. Passive cooling unit (10) of any one of claims 1 to 8, wherein the at least one airflow means (21) is an electrical fan.

10. Passive cooling unit (10) of any one of claims 1 to 9, further comprising a controller (23) adapted to control a ventilation speed of the at least one airflow means (21).

11. Passive cooling unit (10) of any one of claims 1 to 10, further comprising means (25) for blocking fluid flow through at least one of the at least one airflow channel (17) and a controller (23) adapted to control the blocking of fluid flow through the at least one blockable airflow channel (17).

12. Container (5) for storing food, the container (5) comprising:
an interior compartment (5a) for receiving and storing food, and
at least one cooling unit (10) according to any one of claims 1 to 11.

13. Container (5) of claim 12,
wherein at least one cooling unit (10) is arranged in an upper portion of the container (5) within its interior compartment (5a) above food to be received therein, and/or wherein at least one cooling unit (10) is arranged in a lower portion of the container (5) within its interior compartment (5a) below food to be received therein; and
wherein, optionally, the container (5) is a trolley or a galley insert.

14. Container (5) of claim 12 or 13, wherein the container (5) is a trolley and wherein at least one cooling unit (10) is arranged at an outer bottom surface of the trolley facing a floor on which the trolley is movable.

15. Aircraft comprising:
an aircraft galley with at least one trolley receiving space and/or at least one galley insert receiving space;
at least one container according to any one of claims 12 to 14, wherein each container either is a trolley receivable in a trolley receiving space of the aircraft galley or is a galley unit receivable in a galley insert receiving space of the aircraft galley.
